# FASCICULE DE BREVET EUROPEEN

(11) **EP 2 133 910 B1**
(45) Date de publication et mention de la délivrance du brevet: **20.03.2013**
(21) Numéro de dépôt: 09162299.3
(22) Date de dépôt: 09.06.2009
(51) Int. Cl.: H01L 21/385, H01L 33/00, B82Y 40/00, H01L 33/24, H01L 33/28, H01L 29/06, H01S 5/327

(54) **Procédé de passivation des centres de recombinaisons non radiatives d'échantillons en ZnO et échantillons en ZnO passivé ainsi préparés**
Verfahren zur Passivierung der nichtstrahlenden Rekombinationszentren in ZnO-Probenkörpern und so präparierte passivierte ZnO-Probenkörper
Passivation process of non-radiative recombination centres in ZnO samples and so prepared passivated ZnO samples

(30) Priorité: 12.06.2008 FR 0853910
(43) Date de publication de la demande: 16.12.2009
(73) Titulaire: Commissariat à l'Énergie Atomique et aux Énergies Alternatives, 75015 Paris (FR)
(72) Inventeur: Robin, Ivan-Christophe, 38000, Grenoble (FR); Feuillet, Guy, 38410, Saint-Martin d'Uriage (FR)
(74) Mandataire: Augarde, Eric

(56) Documents cités:
- EP-A- 1 677 365
- US-A1- 2004 232 436
- US-A1- 2004 252 737
- HWANG C H ET AL: "Novel processing for improving optical property of InGaN/GaN MQW light emitting diode" PROCEEDINGS OF THE SPIE - THE INTERNATIONAL SOCIETY FOR OPTICAL ENGINEERING SPIE-INT. SOC. OPT. ENG USA, vol. 3938, 2000, pages 124-130, XP002510403 ISSN: 0277-786X
- SADOFEV S ET AL: "Uniform and efficient UV-emitting ZnO/ZnMgO multiple quantum wells grown by radical-source molecular beam epitaxy" JAPANESE JOURNAL OF APPLIED PHYSICS, PART 2 (LETTERS) JAPAN SOC. APPL. PHYS JAPAN, vol. 45, no. 46-50, décembre 2006 (2006-12), pages L1250-L1252, XP002510404 ISSN: 0021-4922

## Description

### DOMAINE TECHNIQUE

L'invention concerne un procédé de passivation des centres de recombinaisons non radiatives d'échantillons en ZnO.

Plus particulièrement l'invention concerne un procédé de passivation des dislocations, notamment dans les couches épitaxiales « 2D » ou les substrats massifs de ZnO, ou des états ou défauts de surface notamment dans les nanofils de ZnO.

L'invention concerne en outre les échantillons en ZnO passivé ainsi préparés.

Le domaine technique de l'invention peut être défini comme celui de la préparation du ZnO sous quelque forme que ce soit, à savoir substrats, nanofils, couches minces, nanostructures, etc. pour des applications notamment en optoélectronique et dans tout dispositif lumineux à base de ZnO tels que Diodes Électroluminescentes (DEL ou LED en langue anglaise), écrans, projecteurs, lasers, lasers à polariton etc.

### ÉTAT DE LA TECHNIQUE ANTÉRIEURE

Pour prendre pleinement avantage de la force de l'exciton dans ZnO afin de réaliser des émetteurs dans l'UV notamment pour les DELs et les lasers, ..., une faible densité de centres de recombinaisons non-radiatives doit être obtenue.

Ces centres de recombinaisons non radiatives sont notamment les dislocations et les états de surface.

Les dislocations sont des centres de recombinaisons non radiatives très efficaces dans les semi-conducteurs et leur densité est un facteur limitant du rendement radiatif en particulier dans le cas des couches minces de ZnO.

Les états de surface, en particulier dans le cas de nanofils, peuvent aussi jouer le rôle de centres de recombinaisons non radiatives.

Actuellement, les couches minces obtenues par croissance de ZnO sur saphir présentent une grande densité de dislocations.

Ainsi le document [1] décrit la croissance de films de ZnO sur du saphir par épitaxie à jets moléculaires avec une couche tampon de MgO. La densité moyenne de dislocations (« threading dislocations ») dans ces films de ZnO est de 4.10⁹/cm².

Dans le cas de substrats massifs obtenus par croissance hydrothermale, la densité de dislocations est de l'ordre de 10⁶-10⁷/cm² comme cela est mentionné dans le document [2].

Le document [3] met en évidence que les alliages Zn₍₁₋ₓ₎MgₓO obtenus par épitaxie par jets moléculaire sur des substrats ZnO ont des rendements radiatifs de luminescence plus importants que ceux de couches de ZnO en particulier à haute température. Aussi bien la largeur de la bande d'émission que la force d'oscillateur de la photoluminescence de ces alliages augmentent nettement avec des teneurs croissantes en magnésium x. Ceci est certainement dû à des fluctuations de la composition en magnésium de l'alliage : MgO ayant une énergie de bande interdite plus grande que ZnO, les excitons se trouvent localisés dans les zones où la concentration de Mg est plus faible. C'est le même phénomène que celui existant dans les alliages InGaN, décrit dans le document [4], où les fluctuations de la composition de l'alliage permettent la localisation des excitons dans les zones riches en indium, loin des défauts.

Les études optiques réalisées dans le document [3], et qui portent donc sur des échantillons dans lesquels un alliage de ZnMgO est directement préparé par croissance, montrent qu'il faut incorporer au moins 15% de magnésium pour augmenter significativement le rendement radiatif de luminescence comparé à ZnO. En outre la croissance de l'alliage de ZnMgO sur le ZnO est extrêmement difficile à maîtriser.

Le document EP-A-1 677 365 décrit un procédé de fabrication d'une diode électroluminescente à semi-conducteur et en particulier d'une diode électroluminescente ayant une structure texturée pour améliorer le rendement d'extraction de la lumière.

Cette diode est préparée en formant une première couche semi-conductrice sur un substrat, et en formant une couche semi-conductrice texturée. à partir de cette couche.

Cette couche texturée peut être préparée en formant une première couche de matériau sur la première couche semi-conductrice, en formant une seconde couche de matériau sur la première couche semi-conductrice et en procédant à un recuit pour que les matériaux de la première et de la seconde couches pénètrent dans la première couche semi-conductrice.

Plus précisément, la première couche semi-conductrice texturée peut être préparée en réalisant un recuit pour que les première et seconde couches pénètrent dans des régions à défauts cristallins, tels que dislocation, de la première couche semi-conductrice.

La première couche peut être en Ni ou en Pd.

La seconde couche peut être en Ag ou en Au.

Le magnésium n'est donc pas cité.

Le recuit est réalisé sous une atmosphère d'azote et non dans une atmosphère oxydante.

Dans ce document, le seul semi-conducteur cité pour la couche semi-conductrice est l'InApGaN à savoir un semi-conducteur III-V et le ZnO n'est ni mentionné, ni évoqué.

Le document de HUANG.- C H et al. "The Novel Processing for improving optical property of InGaN/GaN MQW lïght emitting diode", PROCEEDINGS OF THE SPIE -THE INTERNATIONAL SOCIETY FOR OPTICAL ENGINEERING SPIE-INT. SOC. OPT. ENG USA, vol. 3938, 2000, pages 124-130 décrit un procédé pour améliorer les propriétés optiques de InGaN/GaN.

Ce document met en évidence que l'intensité de photoluminescence de DELs à puits quantiques multiples ("MQW" en langue anglaise) d' InGaN/GaN recuites dans une poudre de AlN peut être améliorée d'un facteur 5 par rapport à des DELs n'ayant pas subi ce traitement.

L' aluminium diffusé convertit l' InGaN/GaN en AlGaN/InGaN.

De manière plus précise, des échantillons constitués par une couche tampon de GaN, 5 paires de « MQW » InGaN/GaN et une couche supérieure de GaN sont préparés sur un substrat en saphir par un procédé de dépôt chimique en phase vapeur d'organométalliques.

Le recuit est réalisé dans des ampoules de quartz sous vide avec du Ga ou de l'AlN en poudre en une quantité suffisante pour établir une surpression de Ga, ou AlN ; ou bien sans surpression. La température de recuit est de 750 à 950°C et la durée de recuit est de quatre heures.

Ce document concerne spécifiquement l'amélioration des propriétés optiques par recuit, de nitrures d'éléments du groupe III et encore plus particulièrement d'une structure InGaN/GaN multi-puits (MQW). Le ZnO n'est ni mentionné, ni révoqué.

On met en oeuvre du nitrure d' Al en poudre et non du magnésium.

Le recuit est effectué sous vide et non dans une atmosphère oxydante.

Le document US-A1-2004/252737 décrit des nanofils de ZnO avec un puits quantique ou une structure quantique coaxiale. Ce puits quantique ou cette structure quantique coaxiale est formé(e) en laminant alternativement une couche d'oxyde de zinc et une couche d'oxyde choisi parmi MgO, ZnMgO, Al₂O₃ et TiO₂.

Il existe donc au vu de ce qui précède, un besoin pour un procédé permettant de passiver les centres de recombinaisons non radiatives du ZnO tels que les états de surface, les dislocations et les autres centres de recombinaisons non radiatives, et par voie de conséquence d'augmenter le rendement radiatif de tout échantillon en ZnO; que cet échantillon en ZnO se présente sous la forme d'un substrat massif, préparé par exemple par un procédé hydrothermal, d'une couche épitaxiale « 2D », ou de nanofils.

Il existe encore un besoin pour un tel procédé qui soit simple, fiable et facilement maîtrisable.

### EXPOSÉ DE L'INVENTION

Le but de la présente invention est de fournir un procédé qui réponde entre autre à ces besoins.

Ce but et d'autres encore sont atteints conformément à l'invention, par un procédé de passivation des centres de recombinaisons non radiatives d'un échantillon en ZnO, dans lequel on dépose du magnésium sur au moins une surface de l'échantillon en ZnO, et on effectue un recuit de l'échantillon sur lequel est déposé le magnésium dans une atmosphère oxydante.

Le procédé selon l'invention s'applique à tout échantillon de ZnO quelle que soit sa forme, sa taille et le procédé ayant permis de l'obtenir.

Ainsi l'échantillon en ZnO peut se présenter sous la forme d'un substrat massif préparé par exemple par un procédé hydrothermal, d'au moins un nanofil, ou d'une couche « 2D » par exemple d'une couche épitaxiale « 2D ».

Les centres de recombinaisons non radiatives peuvent être des dislocations et/ou des états ou défauts de surface, ou tout autre défaut cristallin.

Généralement, lorsque l'échantillon se présente sous la forme d'une couche « 2D », les centres de recombinaisons non radiatives sont des dislocations.

Généralement, lorsque l'échantillon se présente sous la forme de nanofils, les centres de recombinaisons non radiatives sont des états ou défauts de surface.

Avantageusement le recuit est effectué dans une atmosphère d'air, d'oxygène, ou d'air enrichi en oxygène.

Par air enrichi en oxygène on entend que l'oxygène présente une concentration supérieure à sa concentration normale dans l'air.

Avantageusement le recuit est effectué à une température de 400 à 1300°C, de préférence de 500 à 1300°C, de préférence encore de 500 à 1200°C, mieux de 600 à 1200°C, pendant une durée de 5 minutes à 1 jour, de préférence de 30 minutes à 1 jour, de préférence encore de 30 minutes à 10 heures, mieux de 1 heure à 10 heures.

Avantageusement, le magnésium est déposé en une quantité exprimée en MgO de 0,01 à 20% en masse, de préférence de 0,04 à 10% en masse, de préférence encore de 0,5 à 4% en masse, mieux de 0,5 à 3% en masse, mieux encore de 1 à 3% en masse, par exemple 10% en masse de la masse de l'échantillon de ZnO.

Avantageusement, le magnésium est déposé sur les couches épitaxiales 2D ou substrats sous la forme d'une fine couche d'une épaisseur de 0,5 nm à 100 µm, de préférence de 0,5 nm à 10 µm par exemple de 2 nm, ou bien de 2 µm.

Les documents de l'art antérieur cités ci-dessus ne décrivent, ni ne suggèrent l'utilisation du magnésium pour passiver les dislocations, états ou défauts de surface et autres centres de recombinaisons non radiatives d'un échantillon de ZnO.

On peut dire que le procédé selon l'invention consiste à incorporer du magnésium sous forme de MgO, généré à partir d'un dépôt de magnésium, dans un échantillon de ZnO, déjà préparé, après la croissance ou la synthèse du ZnO.

L'apport du magnésium se fait de manière totalement indépendante de la préparation du ZnO, et « a posteriori ».

Cette incorporation est réalisée selon le procédé de l'invention par simple dépôt de magnésium suivi d'un recuit afin de diffuser le magnésium jusqu'au coeur des dislocations pour passiver les états et défauts de surface notamment dans le cas des nanofils de ZnO, et les autres centres de recombinaisons non radiatives.

Le procédé selon l'invention, est simple, fiable, facile à mettre en oeuvre et comporte un nombre limité d'étapes, à savoir : une étape très simple de dépôt de magnésium sur l'échantillon de ZnO après la préparation, croissance du ZnO et ensuite une étape de recuit également facile à réaliser.

Le procédé selon l'invention est facile à maîtriser dans chacune de ses étapes mais aussi lors de l'étape préalable de préparation du ZnO. Le procédé selon l'invention n'implique pas de processus difficiles à contrôler, maîtriser comme la croissance de l'alliage ZnMgO, ou la croissance de ZnO sur ZnMgO ou de ZnMgO sur ZnO.

Le procédé selon l'invention ne nécessite pas d'appareillage complexe et coûteux, en particulier il n'est pas nécessaire d'avoir recours à une cellule de magnésium dans un bâti d'épitaxie à jets moléculaires.

Le procédé selon l'invention permet d'obtenir une augmentation significative du rendement radiatif de luminescence comparé au ZnO non passivé avec une teneur en magnésium beaucoup moins élevée que dans l'art antérieur. Ainsi, selon l'invention, des teneurs en magnésium (exprimées en MgO) aussi faibles que 0,01% en masse permettent d'augmenter significativement le rendement de luminescence, à savoir d'un facteur 20 à température ambiante alors qu'il faut incorporer au moins 15% de magnésium pour augmenter significativement le rendement radiatif de luminescence comparé à ZnO dans le document [3].

Le procédé selon l'invention permet d'obtenir aussi une couche de MgO en surface de nanofils ZnO sans réaliser de croissance latérale de MgO.

Le magnésium, par un procédé simple de type évaporation est incorporé au niveau des centres de recombinaisons non radiatives, sélectivement, ce qui n'est pas le cas quand on obtient de la « fluctuation d'alliage », correspondant à des compositions de magnésium inhomogène, par croissance de ZnMgO. En effet, les zones riches en magnésium ne sont pas au niveau des centres de recombinaisons non radiatives quand le ZnMgO est élaboré directement par croissance.

Le procédé selon l'invention qui passive de manière efficace et avec une quantité réduite de magnésium les centres de recombinaisons non radiatives du ZnO quels qu'ils soient permet d'augmenter le rendement radiatif de tout échantillon à base de ZnO : ceci est particulièrement intéressant du fait que le ZnO est déjà un matériau ayant des propriétés exceptionnelles pour l'émission dans l'UV (grand gap, force de l'exciton élevée de 60 meV...).

Il a en outre été constaté que dans le cas de nanofils, le procédé selon l'invention peut aussi permettre de fortement augmenter la mobilité des porteurs du fait de la formation latérale de ZnMgO.

Le procédé selon l'invention permet de préparer un ZnO passivé, par exemple sous la forme de nanofils, jamais obtenu dans l'art antérieur et qui présente intrinsèquement en tant que tel des caractéristiques et propriétés qui n'ont jamais été obtenues précédemment par quelque procédé que ce soit.

L'invention concerne donc en outre un échantillon en ZnO préparé par le procédé selon l'invention dans lequel les centres de recombinaisons non radiatives sont passivés par du ZnMgO ou du MgO.

Par « passivé », au sens de l'invention, on entend généralement que les centres de recombinaisons non radiatives sont entourés de et en contact avec ZnMgO ou MgO.

L'échantillon peut se présenter sous la forme de nanofils à structure coeur en ZnO/coquille en ZnMgO ou MgO.

En particulier, comme on l'a déjà précisé, le ZnO préparé selon l'invention présente de manière inhérente un rendement radiatif jamais atteint. Ainsi, l'échantillon de ZnO passivé selon l'invention pourra présenter, pour une teneur en magnésium exprimée en MgO de 0,01 à 20% en masse, de préférence de 0,04 à 10% en masse, de préférence encore de 0,5 à 4%, mieux de 0,5 à 3%, mieux encore de 1 à 3% en masse, un rendement radiatif (rendement radiatif de luminescence) de 10 à 100%, de préférence de 80 à 100%.

Dans le cas où le ZnO se présente sous la forme de nanofils, il présente outre ce rendement radiatif augmenté, élevé, une mobilité des porteurs accrue par rapport à un ZnO sous la forme de nanofils mais n'ayant pas été préparé par le procédé selon l'invention.

Cette mobilité des porteurs accrue, est en plus de l'augmentation du rendement radiatif, une propriété intéressante pour réaliser des composants électroniques à base de nanofils.

Pour la teneur en magnésium mentionnée plus haut, un échantillon de ZnO préparé par le procédé selon l'invention pourra généralement présenter une mobilité des porteurs de 1 à 250 cm²/V.s, de préférence de 150 à 250 cm²/V.s.

L'invention concerne enfin un dispositif optoélectronique tel qu'une diode électroluminescente, ou un laser, comprenant ledit échantillon en ZnO passivé.

L'invention sera mieux comprise à la lecture de la description détaillée qui suit donnée à titre illustratif et non limitatif, en référence aux dessins joints, dans lesquels :
Les Figures 1A, 1B et 1C illustrent la passivation des dislocations d'une couche « 2D » ou d'un substrat massif de ZnO par le procédé selon l'invention par dépôt de Mg puis recuit.
Les Figures 2A, 2B et 2C illustrent la passivation de nanofils de ZnO par le procédé selon l'invention par dépôt de Mg puis recuit.
La Figure 3 est une vue schématique en coupe verticale qui montre les dislocations d'une couche « 2D » passivées par du MgO selon le procédé de l'invention.
Les Figures 4A et 4B montrent les états de surface de nanofils passivés par du MgO selon le procédé de l'invention.

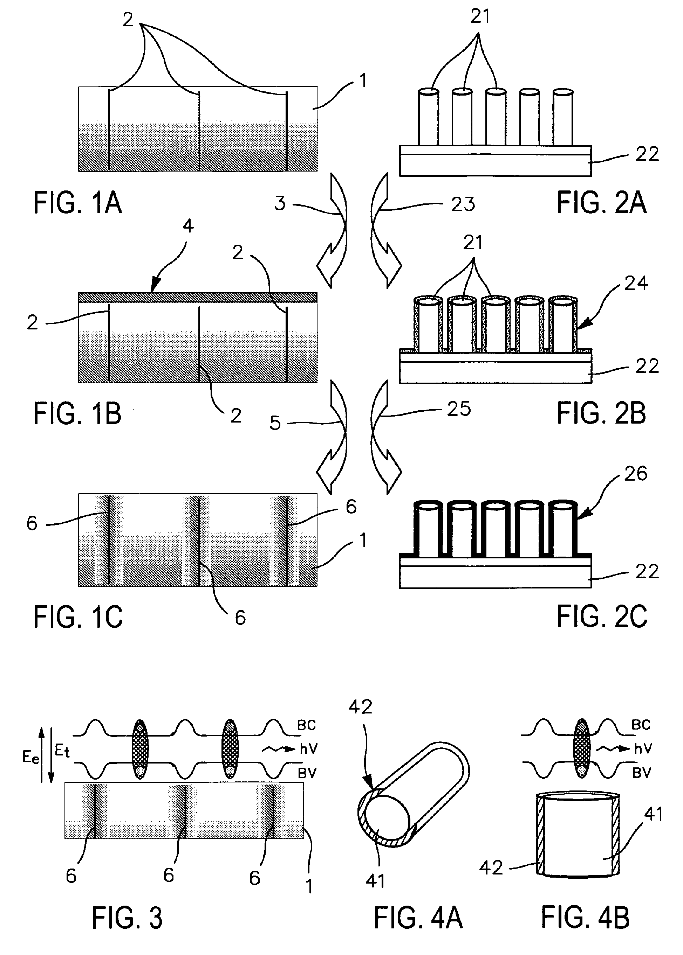

Le procédé selon l'invention dans le cas où l'on réalise la passivation des dislocations d'une couche « 2D » ou d'un substrat massif est illustré sur les Figures 1A, 1B et 1C.

Sur la figure 1A, on a représenté en coupe verticale un échantillon de ZnO (1) qui est sous la forme d'une couche mince « 2D » d'une épaisseur généralement de 2 nm à 1 mm ou d'un substrat massif par exemple d'une épaisseur de 0,5 mm.

La couche « 2D » est généralement préparée par un procédé de croissance épitaxiale sur un substrat (non représenté) généralement en Al₂O₃ ou en GaN.

Le substrat massif est généralement préparé par un procédé de croissance hydrothermal.

Le substrat ou la couche présentent des dislocations (2).

La densité de ces dislocations peut être de 10³ à 10¹⁰ /cm².

Conformément au procédé selon l'invention on dépose du magnésium (flèche 3) sur au moins une surface de l'échantillon en ZnO.

Le dépôt de magnésium (4) peut prendre différentes formes.

Ce dépôt peut prendre notamment la forme d'une couche de magnésium (4), déposée de préférence sur la surface supérieure de la couche « 2D » (1) ou du substrat massif comme cela est représenté sur la Figure 1B.

Le dépôt du magnésium peut se faire par toute technique adéquate, par exemple par pulvérisation cathodique ou bien dans un bâti d'épitaxie.

Le dépôt du magnésium peut être avantageusement réalisé à l'issue de la fabrication, de la croissance du ZnO (quelle que soit sa forme : substrat massif, couche « 2D » ou bien encore nanofils) et immédiatement après celle-ci. En d'autres termes, on peut faire suivre la croissance du ZnO par le dépôt du magnésium réalisé avantageusement par la croissance d'une couche de magnésium.

Du fait que le magnésium diffuse préférentiellement le long des dislocations, une faible quantité de magnésium est nécessaire pour passiver les dislocations d'une couche « 2D » ou d'un substrat, même avec des densités de dislocations élevées par exemple de 10⁸ à 10¹⁰ /cm².

Typiquement, une épaisseur de 2 nm de magnésium (exprimée en quantité équivalent de MgO) suffit généralement à passiver les dislocations d'une couche « 2D » de 500 nm d'épaisseur comme cela a été démontré par des résultats expérimentaux obtenus par les inventeurs.

Cependant, le dépôt d'une quantité plus importante de magnésium peut être souhaitable, typiquement, une quantité en MgO équivalente de 0,04 à 20%, de préférence de 1 à 4 % de la quantité de ZnO à traiter. Le dépôt de Mg est un procédé rapide, beaucoup plus rapide que la croissance de ZnMgO.

L'étape suivante du procédé selon l'invention (flèche 5) est une étape de recuit de l'échantillon (1) sur au moins une surface duquel a été déposé du magnésium (4).

Cette étape de recuit (5) est, conformément à l'invention, réalisée dans une atmosphère oxydante, à savoir généralement une atmosphère d'air, d'oxygène ou d'air enrichi en oxygène.

Le recuit (5) est effectué à une température et pendant une durée suffisante pour que le magnésium migre le long des défauts, par exemple le long des dislocations, des lacunes, dans le cas d'une couche « 2D » (Figures 1A à 1C) et soit oxydé sous forme de MgO, et que le MgO diffuse autour des défauts.

Du fait que le recuit a notamment pour but d'oxyder le magnésium sous la forme de MgO. Un recuit sous vide ne conviendrait pas pour l'étape de recuit du procédé selon l'invention, à moins que le magnésium n'ait été oxydé en MgO, en particulier par l'air, au préalable.

Avantageusement, le recuit, notamment dans le cas d'un recuit à l'air est effectué à une température de 400 à 1300°C, de préférence de 500 à 1300°C, de préférence encore de 500 à 1200°C, mieux de 600 à 1200°C, pendant une durée suffisante pour faire diffuser le MgO autour des défauts. Cette durée peut être facilement déterminée par l'homme du métier, et dépend notamment de la nature et de la taille de l'échantillon de ZnO, elle peut aller de 5 minutes à 1 jour, de préférence de 30 minutes à 1 jour, de préférence encore de 30 minutes à 10 heures, mieux de 1 heure à 10 heures.

A l'issue de l'étape de recuit du procédé selon l'invention on obtient, comme cela est représenté sur la figure 1C une couche « 2D » ou un substrat de ZnO dans lesquels les dislocations sont passivées c'est-à-dire entourées de et en contact avec ZnMgO ou MgO (6).

Sans vouloir être lié par une quelconque théorie, il a été observé que le magnésium diffuse facilement dans les semi-conducteurs II-VI le long des sites du groupe II de la maille (à savoir Zn dans le cas de ZnO).

Ainsi les dislocations des couches « 2D » ou des substrats massifs peuvent représenter des chemins préférentiels de diffusion du magnésium.

Cette propriété est très intéressante et est mise à profit dans le procédé selon l'invention car comme on l'a évoqué plus haut, les dislocations représentent des centres de recombinaisons non radiatives très efficaces.

Si du ZnMgO ou du MgO est formé autour des dislocations par oxydation de magnésium ayant diffusé le long des dislocations comme cela se produit dans le procédé selon l'invention à l'issue du recuit, une barrière de potentiel est obtenue autour de ces dislocations du fait que le ZnMgO ou le MgO a une plus grande énergie de bande interdite que le ZnO.

Cette barrière de potentiel empêche les excitons de se recombiner non radiativement sur les dislocations et un meilleur rendement radiatif du matériau est obtenu.

La figure 3 est une vue schématique en coupe verticale qui montre les dislocations d'une couche « 2D » passivée par du MgO ou du MgZnO (6) selon le procédé de l'invention. Sur cette figure, Eₑ représente l'énergie des électrons, Et représente l'énergie des trous, et BC et BV représentent respectivement les bandes de valence et de conduction.

Le même principe peut être appliqué pour passiver les états ou défauts de surface de nanofils qui agissent aussi comme centres de recombinaisons non radiatives.

Le procédé selon l'invention dans le cas où l'on réalise la passivation des états ou défauts de nanofils est illustré sur les Figures 2A, 2B et 2C.

Sur la figure 2A on a représenté en coupe verticale un échantillon de ZnO qui est sous la forme de nanofils (21) sur un substrat (22).

Les nanofils (21) se présentent généralement sous la forme de cylindres à génératrice circulaire ou hexagonale d'un diamètre généralement de 5 nm à 20 µm et d'une longueur généralement de 50 nm à 20 µm. Le substrat (22) est généralement un substrat en Al₂O₃ ou en GaN ou ZnO.

Les nanofils (21) sont généralement préparés par un procédé d'épitaxie d'organo métalliques ou épitaxie par jets moléculaires sur le substrat.

Les nanofils présentent des défauts ou états de surface, du fait de l'interface elle-même ou du fait de l'inhomogénéité de la surface, due par exemple à la topographie, à la rugosité, à la composition.

Conformément au procédé selon l'invention on dépose du magnésium (flèche 23) sur au moins une surface de l'échantillon en ZnO

Le dépôt de magnésium peut dans le cas général prendre différentes formes

Dans le cas de nanofils de ZnO (21) ce dépôt peut prendre notamment la forme d'une couche de magnésium (24), déposée sur au moins une surface des nanofils (21) et de préférence sur toute la surface externe des nanofils (21) et du substrat, comme cela est représenté sur la Figure 2B.

Le dépôt du magnésium (23) peut se faire par toute technique adéquate, par exemple par pulvérisation cathodique ou bien dans un bâti d'épitaxie.

Le dépôt du magnésium (23) peut être avantageusement réalisé à l'issue de la fabrication, de la croissance du ZnO pour préparer les nanofils et immédiatement après celle-ci. En d'autres termes on peut faire suivre la croissance du ZnO pour préparer les nanofils, par le dépôt du magnésium.

Ce dépôt de magnésium (23) est, dans le cas des nanofils, réalisé avantageusement par la croissance d'une couche de magnésium (24) de préférence d'une couche mince de magnésium par exemple d'une épaisseur de 0,5 à 100 nm.

Une faible quantité de magnésium est nécessaire pour passiver les états ou défauts de surface de nanofils, même avec des densités d'états ou de défauts de surface élevées par exemple de 10⁸ à 10¹⁰ /cm².

Typiquement, une épaisseur de 2 nm de magnésium (exprimée en quantité équivalente de MgO) suffit généralement à passiver les états ou défauts de surface de nanofils d'une taille de 2 µm de long et 200 nm de diamètre, ce qui correspond à environ 0,5% de MgO.

Cependant, le dépôt d'une quantité plus importante de magnésium peut être souhaitable, typiquement, une quantité en MgO équivalente de 0,1 à 10%, de préférence de 1 à 2% de la quantité de ZnO à traiter.

L'étape suivante du procédé selon l'invention (flèche 25) est une étape de recuit de l'échantillon sur au moins une surface duquel a été déposé du magnésium.

Les conditions du recuit sont généralement les mêmes que celles décrites plus haut pour la passivation de couches « 2D » ou de substrats massifs.

Le recuit est effectué à une température et pendant une durée suffisante pour que le magnésium soit oxydé sous forme de MgO, que le MgO diffuse autour des centres de recombinaisons non radiatives et que l'on obtienne en surface une coquille de MgO ou de ZnMgO (26) qui jouera le rôle de barrière de potentiel (Figure 2C).

A l'issue de l'étape de recuit du procédé selon l'invention on obtient ainsi, comme cela est représenté sur les figures 4A et 4B des nanofils de ZnO (41) pourvus en surface d'une coquille de MgO (ou MgZnO) (42) jouant le rôle de barrière de potentiel.

Les excitons ne peuvent alors plus se recombiner non radiativement en surface. Cette technique est une manière commode de réaliser des nanofils de structure coeur/coquille (« core/shell ») ZnO/ZnMgO ou ZnO/MgO. Le confinement latéral ainsi obtenu peut aussi permettre d'augmenter la mobilité des charges dans les nanofils.

Il est à noter que dans le cas de nanofils de ZnO, le magnésium migre aussi vers l'intérieur du nanofil après son dépôt tout en étant aussi présent en surface pour passiver les états de surface.

On peut donc dire que dans le cas des nanofils, les centres de recombinaisons non radiatives sont aussi entourés de et en contact avec du ZnMgO ou du MgO.

Le procédé selon l'invention peut être utilisé pour la passivation du ZnO mis en oeuvre dans toutes sortes de dispositifs optoélectroniques tels que les diodes électroluminescentes à base de ZnO et les lasers à base de ZnO.

Le procédé selon l'invention peut notamment trouver son application dans les diodes électroluminescentes à base de ZnO, dans lesquelles on peut réaliser le traitement de toutes les couches contenant du ZnO par un dépôt de MgO pour augmenter le rendement radiatif de la diode.

Le procédé selon l'invention peut aussi permettre d'éviter de réaliser des puits quantiques ZnMgO/ZnO/ZnMgO dans la zone d'émission d'une diode électroluminescente ou d'un laser.

Le confinement est obtenu naturellement loin des défauts. La localisation peut éventuellement être aussi efficace que dans un puits quantique et est obtenue par un procédé beaucoup plus simple puisqu'il n'est plus nécessaire de maîtriser la croissance de l'alliage ZnMgO, ni la croissance de ZnO sur ZnMgO.

L'invention va maintenant être décrite en relation avec les exemples suivants, donnés à titre illustratif et non limitatif.

### EXEMPLE 1

On dépose du magnésium par évaporation sur un substrat ou une couche « 2D » de ZnO réalisée par épitaxie par jets moléculaires sur un substrat saphir et on recuit l'échantillon pendant 4 heures à l'air à 800°C. On obtient ainsi une couche « 2D » passivée.

### EXEMPLE 2

On dépose du magnésium par évaporation sur un échantillon de nanofils en ZnO obtenus par croissance d'organo métalliques (du diéthylzinc en présence de protoxyde d'azote) sur un substrat saphir et on recuit ensuite l'échantillon pendant 4 heures à l'air à 800°C. On obtient ainsi des nanofils passivés.

### REFERENCES

[1] B. Pécz, A. El-Shaer, A. Bakin, A. C. Mofor, A. Waag and J. Stoemenos, J. Appl. Phys., vol. 100, page 103506 (2006).
[2] C. Neumann, Ph.D. Thesis, Physikalisches Institut, Justus-Liebig-Universität, Gießen, Germany, 2006.
[3] H. Shibata, H. Tampo, K. Matsubara, A. Yamada, K. Sakurai, S. Ishizuka, S. Niki and M. Sakai, Appl. Phys. Lett., vol. 90, page 124104 (2007).
[4] D. Gerthsen, E. Hahn, B. Neubauer, A. Rosenauer, O. Schon, M. Heuken and A. Rizzi, Phys. Status Solidi a, vol. 177, page 145 (2000).

## Revendications

1. Procédé de passivation des centres de recombinaisons non radiatives d'un échantillon en ZnO (1,21,41), dans lequel on dépose (3,23) du magnésium (4,24) sur au moins une surface de l'échantillon en ZnO, et on effectue un recuit (5,25) de l'échantillon sur lequel est déposé le magnésium dans une atmosphère oxydante.

2. Procédé selon la revendication 1 dans lequel l'échantillon en ZnO se présente sous la forme d'un substrat massif (1) d'au moins un nanofil (21,41), ou d'une couche « 2D » (1).

3. Procédé selon l'une quelconque des revendications précédentes dans lequel les centres de recombinaisons non radiatives sont des dislocations (2) et/ou des états ou défauts de surface, ou tout autre défaut cristallin.

4. Procédé selon l'une quelconque des revendications précédentes dans lequel l'échantillon se présente sous la forme d'une couche « 2D » (1), et les centres de recombinaisons non radiatives sont des dislocations (2).

5. Procédé selon l'une quelconque des revendications 1 à 3 dans lequel l'échantillon se présente sous la forme de nanofils (21) et les centres de recombinaisons non radiatives sont des états ou défauts de surface.

6. Procédé selon l'une quelconque des revendications précédentes dans lequel le recuit (5,25) est effectué dans une atmosphère d'air, d'oxygène, ou d'air enrichi en oxygène.

7. Procédé selon l'une quelconque des revendications précédentes dans lequel le recuit (5,25) est effectué à une température de 400 à 1300°C, de préférence de 500 à 1300 °C, de préférence encore de 500 à 1200°C; mieux de 600 à 1200°C, pendant une durée de 5 minutes à 1 jour, de préférence de 30 minutes à 1 jour, de préférence encore de 30 minutes à 10 heures, mieux de 1 heure à 10 heures.

8. Procédé selon l'une quelconque des revendications précédentes dans lequel le magnésium est (4,24) est dépose (3,23) en une quantité exprimée en MgO de 0,01 à 20% en masse, de préférence de 0,04 à 10% en masse, de préférence encore de 0,5 à 4% en masse, mieux de 0, 5 à 3% en masse, mieux encore de 1 à 3% en masse de la masse de l'échantillon de ZnO.

9. Procédé selon l'une quelconque des revendications précédentes dans lequel le magnésium (4,24) est dépose (3,23) sous la forme d'une fine couche d'une épaisseur de 0,5 nm à 100 µm, de préférence de 0,5 nm à 10 µm par exemple de 2 nm, ou bien de 2 µm.

10. échantillon en ZnO (1,21,41) préparé par le procédé selon l'une quelconque des revendications 1 à 9, dans lequel les centres de recombinaisons non radiatives sont passivés par du ZnMgO ou du MgO (6,26,42).

11. Echantillon en ZnO selon la revendication 10 dans lequel l'échantillon se présente sous la forme de nanofils à structure coeur (21,41) ZnO/coquille (26,42) en ZnMgO ou MgO.

12. Echantillon en ZnO selon l'une quelconque des revendications 10 et 11 qui présente une teneur en masse en magnésium, exprimée en MgO de 0,01 à 20% en masse, de préférence de 0,04 à 10% en masse, de préférence encore de 0,5 à 4% en masse, mieux de 0,5 à 3% en masse, mieux encore de 1 à 3% en masse du ZnO et un rendement radiatif de luminescence de 10 à 100%, de préférence de 80 à 100%.

13. Echantillon selon la revendication 12 qui se présente sous la forme de nanofils (21) et qui présente en outre une mobilité des porteurs de 1 à 250 cm²/V.s, de préférence de 150 à 250 cm²/V.s.

14. Dispositif optoélectronique tel qu'une diode électroluminescente, un laser comprenant un échantillon de ZnO selon l'une quelconque des revendications 10 à 13.

## Claims

1. Method for passivating the non-radiative recombination centres of a ZnO sample (1, 21, 41), wherein magnesium (4, 24) is deposited (3, 23) on at least one surface of the ZnO sample and the sample whereon the magnesium is deposited is annealed (5, 25) in an oxidising atmosphere.

2. Method according to claim 1 wherein the ZnO sample is in the form of a solid substrate (1), of at least one nanowire (21, 41) or of a "2D" layer (1).

3. Method according to any one of the preceding claims wherein the non-radiative recombination centres are dislocations (2) and/or surface states or defects, or any other crystalline defect.

4. Method according to any one of the preceding claims wherein the sample is in the form of a "2D" layer (1) and the non-radiative recombination centres are dislocations (2).

5. Method according to any one of claims 1 to 3 wherein the sample is in the form of nanowires (21) and the non-radiative recombination centres are surface states or defects.

6. Method according to any one of the preceding claims wherein the annealing (5, 25) is performed in an air, oxygen or oxygen-enriched air atmosphere.

7. Method according to any one of the preceding claims wherein the annealing (5, 25) is performed at a temperature of 400 to 1300°C, preferably 500 to 1300°C, more preferably 500 to 1200°C, better 600 to 1200°C, for a time of 5 minutes to 1 day, preferably 30 minutes to 1 day, more preferably 30 minutes to 10 hours, better 1 hour to 10 hours.

8. Method according to any one of the preceding claims wherein the magnesium (4, 24) is deposited (3, 23) in a quantity expressed as MgO of 0.01 to 20% by mass, preferably 0.04 to 10% by mass, more preferably 0.5 to 4% by mass, better 0.5 to 3% by mass, even better 1 to 3% by mass of the mass of the ZnO sample.

9. Method according to any one of the preceding claims wherein the magnesium (4, 24) is deposited (3, 23) in the form of a thin layer 0.5 nm to 100 µm in thickness, preferably 0.5 nm to 10 µm, for example 2 nm or 2 µm.

10. ZnO sample (1, 21, 41) prepared using the method according to any one of claims 1 to 9, wherein the non-radiative recombination centres are passivated with ZnMgO or MgO (6, 26, 42).

11. ZnO sample according to claim 10 wherein the sample is in the form of ZnO core (21, 41)/ZnMgO or MgO shell (26, 42) structured nanowires.

12. ZnO sample according to any one of claims 10 and 11 having a magnesium content by mass, expressed as MgO, of 0.01 to 20% by mass, preferably 0.04 to 10% by mass, more preferably 0.5 to 4% by mass, better 0.5 to 3% by mass, even better 1 to 3% by mass of the ZnO and a radiative luminescence output of 10 to 100%, preferably 80 to 100%.

13. Sample according to claim 12 in the form of nanowires (21) and further having a carrier mobility of 1 to 250 cm²/V.s, preferably 150 to 250 cm²/V.s.

14. Optoelectronic device such as a light-emitting diode, a laser, comprising a ZnO sample according to any one of claims 10 to 13.

## Patentansprüche

1. Verfahren zur Passivierung der nichtstrahlenden Rekombinationszentren eines ZnO-Probenkörpers (1, 21, 41), bei dem man auf mindestens einer Seite des ZnO-Probenkörpers Magnesium (4, 24) abscheidet (3, 23) und man ein Tempern (5, 25) des Probenkörpers, auf dem das Magnesium abgeschieden ist, in einer oxidierenden Atmosphäre durchführt.

2. Verfahren nach Anspruch 1, bei dem der ZnO-Probenkörper sich in Form eines massiven Substrats (1), wenigstens einer Nanofaser (21, 41) oder einer 2D-Schicht (1) präsentiert.

3. Verfahren nach einem der vorhergehenden Ansprüche, bei dem die nichtstrahlenden Rekombinationszentren Dislokationen (2) und/oder Oberflächenzustände oder -defekte oder irgend ein anderer Kristalldefekt sind.

4. Verfahren nach einem der vorhergehenden Ansprüche, bei dem der Probenkörper sich in Form einer 2D-Schicht (1) präsentiert und die nichtstrahlenden Rekombinationszentren Dislokationen (2) sind.

5. Verfahren nach einem der Ansprüche 1 bis 3, bei dem der Probenkörper sich in Form einer Nanofaser (21) präsentiert und die nichtstrahlenden Rekombinationszentren Oberflächenzustände oder-defekte sind.

6. Verfahren nach einem der vorhergehenden Ansprüche, bei dem das Tempern (5, 25) in einer Atmosphäre aus Luft, Sauerstoff oder sauerstoffangereicherter Luft stattfindet.

7. Verfahren nach einem der vorhergehenden Ansprüche, bei dem das Tempern (5, 25) bei einer Temperatur von 400 bis 1300 °C, vorzugsweise 500 bis 1300 °C, besser 500 bis 1200 °C, noch besser 600 bis 1200 °C während einer Dauer von 5 Minuten bis 1 Tag, vorzugsweise von 30 Minuten bis 1 Tag, besser von 30 Minuten bis 10 Stunden, noch besser von 1 Stunde bis 10 Stunden stattfindet.

8. Verfahren nach einem der vorhergehenden Ansprüche, bei dem das Magnesium (4, 24) abgeschieden wird (3, 23) in einer in MgO ausgerückten Menge von 0,01 bis 20 % Massenanteil, vorzugsweise 0,04 bis 10 % Massenanteil, besser 0,5 bis 4 % Massenanteil, wieder besser 0,5 bis 3 % Massenanteil und nochmals besser 1 bis 3 % Massenanteil an der Masse des ZnO-Probenkörpers.

9. Verfahren nach einem der vorhergehenden Ansprüche, bei dem das Magnesium (4, 24) in Form einer dünnen Schicht abgeschieden wird (3, 23), mit einer Dicke von 0,5 nm bis 100 µm, vorzugsweise von 0,5 nm bis 10 µm, zum Beispiel von 2 nm, oder auch von 2 µm.

10. ZnO-Probenkörper (1, 21, 41), hergestellt gemäß dem Verfahren nach einem der Ansprüche 1 bis 9, bei dem die nichtstrahlenden Rekombinationszentren durch ZnMgO oder MgO (6, 26, 42) passiviert werden.

11. ZnO-Probenkörper nach Anspruch 10, wobei der Probenkörper sich in Form von Nanofasern mit einer Struktur des Typs ZnO-Kern (21, 41)/ZnMgO- oder MgO-Schale (26, 42) präsentiert.

12. ZnO-Probenkörper nach einem der Ansprüche 10 und 11, der einen in MgO ausgedrückten Magnesiummassenanteil von 0,01 bis 20 %, bevorzugt von 0,04 bis 10 %, noch bevorzugter von 0,5 bis 4%, besser von 0,5 bis 3 %, noch besser von 1 bis 3 % der ZnO-Masse und einen Lumineszenzstrahlungs-Wirkungsgrad von 10 bis 100 %, vorzugsweise von 80 bis 100 %, präsentiert.

13. Probenkörper nach Anspruch 12, der sich in Form von Nanofasern (21) präsentiert, und der außerdem eine Trägermobilität von 1 bis 250 cm² /V.s, vorzugsweise von 150 bis 250 cm²/V.s präsentiert.

14. Optoelektronische Vorrichtung wie zum Beispiel eine Elektrolumineszenzdiode, ein Laser mit einem ZnO-Probenkörper nach einem der Ansprüche 10 bis 13.
